# EUROPEAN PATENT SPECIFICATION

(11) **EP 4 275 462 B1**
(45) Date of publication and mention of the grant of the patent: **15.05.2024**
(21) Application number: 22809168.2
(22) Date of filing: 01.11.2022
(51) Int. Cl.: H10N 30/88, H10N 30/20, H02N 2/00

(54) **MOUNTING ARRANGEMENT FOR PIEZO MOTOR ELEMENT**
ANORDNUNG ZUR BEFESTIGUNG EINES PIEZOMOTORELEMENTS
DISPOSITIF DE MONTAGE D'UN ÉLÉMENT DE MOTEUR PIÉZOÉLECTRIQUE

(30) Priority: 01.11.2021 EP 21205838
(43) Date of publication of application: 15.11.2023
(73) Proprietor: Xeryon BV, 3001 Heverlee (Leuven) (BE)
(72) Inventor: WAUMANS, Tobias, 3001 Heverlee (Leuven) (BE); PEIRS, Jan, 3001 Heverlee (Leuven) (BE)
(74) Representative: IPLodge bv
(86) International application number: PCT/EP2022/080469
(87) International publication number: WO 2023/073250

(56) References cited:
- EP-A2- 0 978 886
- WO-A1-2018/083205
- JP-A- H07 107 758
- CI P ET AL: "A Square-Plate Piezoelectric Linear Motor Operating in Two Orthogonal and Isomorphic Face-Diagonal-Bending Modes", IEEE TRANSACTIONS ON ULTRASONICS, FERROELECTRICS, AND FREQUENCY CONTROL, vol. 61, no. 1, January 2014 (2014-01), pages 159-165, XP011536253, DOI: 10.1109/TUFFC.2014.6689783

## Description

### Field of the invention

The present invention relates to piezo motors, e.g. ultrasonic piezo motors, and methods of mounting elements of the piezo motors. More particularly, the present invention relates to methods and systems for connecting or mounting a piezo motor element, e.g. an ultrasonic piezo motor element, to a stator component of a positioning device.

### Background of the invention

Piezo actuators are often used in a multitude of applications which require a high degree of miniaturization. The biggest limitation of the typical piezo positioners however is the very small displacement. To counter this effect several principles of piezo motors have been presented which have a limitless travel range.

Three main types of piezo motors have been designed with unlimited strokes: (1) stepping motors, (2) stick-slip/inertia driven motors and (3) resonant motors. Stepping motors have a high holding force but are often too slow for many applications. Stick-slip motors achieve speeds in the order of 10 mm/s but however often cause excessive vibrations. Resonant motors, which are often called 'ultrasonic' because of the high operating frequencies, on the contrary achieve the highest speeds, in the order of 100 mm/s or more. This is because the piezo element(s) of resonant motors are excited with driving signals at a frequency which is close to two eigenfrequencies of the motor. A typical piezo motor has for instance a longitudinal and a transverse moving eigenmode which nearly coincide in frequency. Small ultrasonic piezo motors are characterized by a high power efficiency when compared to electrical motors of the same size. Because of their compactness and efficiency, they are often used for handheld devices. Ultrasonic piezo motors are silent motors because of the high frequency operation. Another advantage of these motors is the lack of any transmission system like gears or belts. The actuation mechanism is therefore less complex and free of mechanical backlash. This means that these motors can achieve a better positioning accuracy. Even when shut down, these motors will still exert a holding force and therefore the position of the sample to be moved is fixed. Some applications also require the actuation to be back-drivable. This means that the sample can still be moved manually and that the impact of hard collisions, e.g. when hitting a hard target, can be limited. Like other piezo motors, ultrasonic piezo motors are often used in specific environments such as: in high or ultra-high vacuum, when magnetic fields are to be avoided, in cryogenic circumstances... But these motors are also used for applications in atmosphere, typically when there is a need for both compactness and high speed.

Although several ultrasonic motors, operating by resonant vibration modes, have been designed over the last years, they still have some drawbacks.

Japanese patent application publication no. JP H07 107758 A discloses an ultrasonic motor with a piezoelectric actuatoraccording to the preamble of independent claim 1, wherein high-frequency voltages of different phases are applied to two sets of electromechanical energy transducers. Standing-wave vibrations are generated in a resonator and node parts of the standing-wave vibrations are fixed by a holding means using an elastic hinge structure.

European patent application publication no. EP 0978886 A2 discloses an ultrasonic motor meant to reduce leakage of the drive force generated by a piezoelectric element and to efficiently transmit the drive force to a moving member. The ultrasonic motor is provided with a piezoelectric element to be oscillated by an input drive signal to generate a drive force, and support members for supporting the piezoelectric element on a substrate. The support member has a signal supply function to supply the drive signal to the piezoelectric element. Accordingly, because there is no necessity of separately providing a signal transmission means, vibration caused by the piezoelectric element leaks less than in a conventional arrangement. Consequently, the ultrasonic motor efficiently transmits drive force to the moving member. Also, the support member is given elasticity by providing a constriction, whereby the support member also provides a press-contact function to press-contact the piezoelectric element with the moving member. In this case, the vibration leakage is further reduced.

Further exemplary ultrasonic motors comprising square piezoelectric plate vibrators with specific supports are known from P. Ci et al, IEEE Transactions on Ultrasonics, Ferroelectrics and Frequency Control, vol. 61, no. 1, January 2014, pages 159-165, and WO 2018/083205 A1.

Nevertheless, there is still a demand for compact ultrasonic piezo motors and for piezo motors that are easy to install.

### Summary of the invention

It is an object of the present invention to provide a good mounting system and method for mounting elements of an ultrasonic piezo motor.

It is an advantage of embodiments of the present invention that the motor elements are held in place by removing the appropriate degrees of freedom of the piezo motor elements. It is an advantage of embodiments of the present invention that all but one degrees of freedom of the piezo motor elements are removed. It is an advantage of embodiments of the present invention that the motor is able to move in the direction normal to the sliding direction, in order to generate a preloading force between the driving contact of the motor and the traction surface of the positioning device.

It is an advantage of embodiments of the present invention that the preloading force can be applied by means of a mechanical spring component, the present invention not being limited thereto.

It is an advantage of embodiments of the present invention that the mounting does not obstruct the ultrasonic driving vibration generated when exciting the piezo motor at its resonance frequencies. It is an advantage of embodiments of the present invention that the fixation points are selected such that there is no or minimal interaction with the eigenmodes of the piezo motor at resonance. The latter results in good force and travel speed of the positioning device.

The fixation points are those positions where the piezo element is fixed to other elements. Aside from the driving contact, these are the only positions where the piezo is in contact with surrounding elements.

It is an advantage of embodiments of the present invention that the method and system has no or minimal play or backlash in the driving direction of the motor.

It is an advantage of embodiments of the present invention that the mounted motor elements are realized in a very compact manner, resulting thus in a compact system.

It is an advantage of embodiments of the present invention that the mounting of the motor elements may be realized by means of inexpensive manufacturing processes, such as for example punching, laser cutting or alike, allowing to have a low fabrication cost. It is an advantage of embodiments of the present invention that the assembly time is short.

It is an advantage of embodiments of the present invention that a method and system is provided that provides symmetry, reducing the effect on the motor resonance modes. It is an advantage of embodiments of the present invention that a good thermal stability of the resulting positioning system is obtained. It is an advantage of embodiments of the present invention that a large degree of symmetry in the device is obtained, resulting in improved stability.

The object and optionally one or more of the advantages are met by a piezoelectric actuator with mounting according to the independent claim of the present invention. The dependent claims relate to preferred embodiments.

The present invention relates to a piezo actuator, e.g. an ultrasonic piezo actuator, comprising
a piezo motor element having a top and a bottom surface, and
a connection element comprising arms with flexure hinges for fixating the piezo motor element at different fixation positions located at node positions of one or more bending modes of the piezo motor element,
the flexure hinges being such that the piezo motor element is allowed to move in the normal direction and the flexure hinges being stiff in the tangential direction, whereby the flexure arms are fixed to the piezo motor element with a fixation means.

In some embodiments, the connection element may comprise two foil elements being one top connection foil element being positioned at the top side of the piezo motor element and one bottom connection foil element positioned at the bottom side of the piezo motor element. In some embodiments, both the top and bottom connection foil element may have arms with the flexure hinges.

The flexure hinges for contacting the piezo motor element may be configured for contacting the piezo motor element respectively at the top surface of the piezo element and at the bottom surface of the piezo motor element.

Alternatively, a single connection element with arms comprising flexure hinges contacting the piezo motor element at the circumference surface may be provided.

Where in embodiments of the present invention reference is made to a foil, this may refer to a film like structure or thin layer, but also may encompass more thick layers such as for example thin plates. Such plates in some embodiments may for example be bendable.

Where in embodiments of the present invention reference is made to the piezo motor element being allowed to move in the normal direction and the flexure hinges are being stiff in the tangential direction, reference is made to the fact that the flexure hinges are perpendicular to the movement of the expansion mode at the position of the fixation points. The normal direction also may be defined as being radial, with respect to the center position.

The flexure arms may be fixed to the piezo motor element using an adhesive.

The adhesive may be an epoxy adhesive or an acrylate or a polyurethane.

The piezo motor element may have a hole extending through the piezo motor element from the top surface to the bottom surface, and the connection element further may comprise a connection part positioned through the hole in the piezo motor element, the connection part mechanically connecting the top connection foil element and the bottom connection foil element, whereby the different fixation positions are positioned away from the hole, so that at the position of the hole, the connection element and the piezo motor element are not in contact with each other.

The connection part may comprise a spacer ring for spacing the top connection foil element and the bottom connection foil element.

The outer diameter of the spacer ring may be substantially smaller than the inner diameter of the hole in the piezo motor element. In some embodiments, the outer diameter of the spacer ring may be 50µm smaller than the inner diameter of the hole. In some embodiments, substantially smaller than the inner diameter may be less than 90%, e.g. less than 80%, e.g. less than 70% of the inner diameter of the hole.

The connection part may comprise two shim elements, e.g. shim rings, assisting in providing mechanical connection between the top connection foil element and the bottom connection foil element and spacing the foil elements from the piezo motor element.

The dimensions of the connection part may be such that there is play between the shim elements and the top and bottom surface of the piezo motor element in the range of 2 µm to 50 µm, e.g. 2 µm to 20 µm, e.g. about 10 µm.

In embodiments of the present invention, during operation, no forces are generated in the vertical, axial direction and therefore that play in this direction will not cause undesired play or backlash in the driving direction.

Between the piezo motor element and the connection foils, a flexible circuit may be provided for electrical connection to electrodes in the piezo motor element.

Whereas a flexible circuit for connecting the piezo motor element provides a fast and accurate method for electrically connecting the electrodes in the piezo motor element, such electrodes in the piezo motor element also could be connected by means of electrical wiring.

The piezo actuator furthermore may comprise a suspension element for suspending the piezo motor element in such a way that the piezo motor element can move freely in a direction perpendicular to the driving direction while preventing undesired motion in the driving direction.

The suspension element may comprise two suspension foils, one suspension foil positioned at the top side of the piezo motor element and one suspension foil being positioned at the bottom side of the piezo motor element.

The suspension foils may be positioned such that the suspension foils are positioned at the sides of the connection foils facing away from the piezo motor element and that the suspension foils and the connection foils are spaced from each other with shim elements.

The suspension foils, the shim elements and the connection foils may be mechanically connected to each other.

The suspension foils, the shim elements and the connection foils may be mechanically connected to each other using a connection part extending through the central hole of the piezo motor element.

The piezo motor element may be plate shaped.

The electrodes may be electrically connected and configured such that the driving of the electrodes induces in-plane modes.

Electrodes may be electrically connected and configured such that, taking into account the polarity of the piezo motor element, the driving of the electrodes induces an in-plane bending mode and/or an in-plane expansion mode.

Electrodes may be electrically connected and configured such that, taking into account the polarity of the piezo material, the driving of the electrodes induces alternatingly an in-plane bending mode and an in-plane expansion mode.

In some embodiments, the electrodes may be configured such that in-plane modes are used.

An in-plane bending mode may be an oscillation mode wherein adjacent corners move in opposite sense and an in-plane expansion mode may be an oscillation mode wherein the different corners of the top surface move in the same direction being synchronously outward or inward.

In another aspect, the present invention relates to a piezo actuator comprising
a piezo motor element having a top and a bottom surface, and
a connection element comprising two foil elements being one top connection foil element being positioned at the top side of the piezo motor element and one bottom connection foil element positioned at the bottom side of the piezo motor element, the top and bottom connection foil element contacting the piezo motor element at different fixation positions, the connection element thus holding the piezo motor element in place without obstructing the eigenmodes of the piezo motor element at resonance,
the piezo motor element having a hole extending through the piezo motor element from the top surface to the bottom surface, and
wherein the connection element further comprises a connection part positioned through the hole in the piezo motor element, the connection part mechanically connecting the top connection foil element and the bottom connection foil element, whereby the different fixation positions are positioned away from the hole, so that at the position of the hole, the connection element and the piezo motor element are not in contact with each other.

The fixation positions may be at the top surface and/or the bottom surface of the piezo element. Alternatively, the fixation positions may be at a side of the piezo motor element.

It is an advantage of embodiments of the present invention that a compact piezo motor is obtained.

The connection part may comprise a spacer ring for spacing the top connection foil element and the bottom connection foil element.

The outer diameter of the spacer ring may be substantially smaller than the inner diameter of the hole in the piezo motor element. In some embodiments, the outer diameter of the spacer ring may be 50µm smaller than the inner diameter of the hole. In some embodiments, substantially smaller than the inner diameter may be less than 90%, e.g. less than 80%, e.g. less than 70% of the inner diameter of the hole.

The connection part may comprise two shim elements, e.g. shim rings, assisting in providing mechanical connection between the top connection foil element and the bottom connection foil element and spacing the foil elements from the piezo motor element.

The dimensions of the connection part may be such that there is play between the shim elements and the top and bottom surface of the piezo motor element in the range of 2 µm to 50 µm, e.g. 2 µm to 20 µm, e.g. about 10 µm.

It is an advantage of embodiments of the present invention that during operation, no forces are generated in the vertical, axial direction and therefore that play in this direction will not cause undesired play or backlash in the driving direction.

Between the piezo motor element and the connection foils, a flexible circuit may be provided for electrical connection to electrodes in the piezo motor element.

Whereas a flexible circuit for connecting the piezo motor element provides a fast and accurate method for electrically connecting the electrodes in the piezo motor element, such electrodes in the piezo motor element also could be connected by means of electrical wiring.

The piezo actuator furthermore may comprise a suspension element for suspending the piezo motor element in such a way that the piezo motor element can move freely in a direction perpendicular to the driving direction while preventing undesired motion in the driving direction.

The suspension element may comprise two suspension foils, one suspension foil positioned at the top side of the piezo motor element and one suspension foil being positioned at the bottom side of the piezo motor element.

The suspension foils may be positioned such that the suspension foils are positioned at the sides of the connection foils facing away from the piezo motor element and that the suspension foils and the connection foils are spaced from each other with shim elements.

The suspension foils, the shim elements and the connection foils may be mechanically connected to each other.

The suspension foils, the shim elements and the connection foils may be mechanically connected to each other using a connection part extending through the central hole of the piezo motor element. The piezo motor element may be plate shaped.

Electrodes may be electrically connected and configured such that, taking into account the polarity of the piezo motor element, the driving of the electrodes induces an in-plane bending mode and/or an in-plane expansion mode.

Electrodes may be electrically connected and configured such that, taking into account the polarity of the piezo material, the driving of the electrodes induces alternatingly an in-plane bending mode and an in-plane expansion mode.

An in-plane bending mode may be an oscillation mode wherein adjacent corners move in opposite sense and an in-plane expansion mode may be an oscillation mode wherein the different corners of the top surface move in the same direction being synchronously outward or inward.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter. Further features of the present invention will become apparent from the examples and figures.

### Brief description of the drawings

FIG. 1 schematically illustrates motor elements of an ultrasonic piezo motor with mounting features according to embodiments of the invention.
FIG. 2 illustrates a cross-sectional view according to line A-A of the motor elements as shown in FIG. 1.
FIG. 3 to 5 illustrate an overview (FIG. 3), a cross-sectional view (FIG. 4) and a detailed view of a part of the cross-section (FIG. 5) of motor elements of an ultrasonic piezo motor with mounting features according to embodiments of the present invention.
FIG. 6 to 9 illustrate different components (layers) of an ultrasonic piezo motor with mounting features according to embodiments of the present invention, wherein FIG. 6 illustrates the piezo-motor, FIG. 7 illustrates a flexprint, FIG. 8 illustrates a connection foil and FIG. 9 illustrates a suspension foil as can be used in embodiments of the present invention.
FIG. 10 illustrates an example of a piezo motor according to an embodiment of the present invention.

The drawings are only schematic and are non-limiting. In the drawings, the size of some of the elements may be exaggerated and not drawn on scale for illustrative purposes. Any reference signs in the claims shall not be construed as limiting the scope. In the different drawings, the same reference signs refer to the same or analogous elements.

### Detailed description of preferred embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. Where the term "comprising" is used in the present description and claims, it does not exclude other elements or steps. Where an indefinite or definite article is used when referring to a singular noun e.g. "a" or "an", "the", this includes a plural of that noun unless something else is specifically stated. The term "comprising", used in the claims, should not be interpreted as being restricted to the means listed thereafter; it does not exclude other elements or steps. Thus, the scope of the expression "a device comprising means A and B" should not be limited to devices consisting only of components A and B. It means that with respect to the present invention, the only relevant components of the device are A and B. Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein. Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

In the drawings, like reference numerals indicate like features; and, a reference numeral appearing in more than one figure refers to the same element. The drawings and the following detailed descriptions show specific embodiments of an actuator, more particularly of a piezoelectric actuator. Where in embodiments of the present invention reference is made to a piezoelectric material, reference is made to materials showing the effect that electric charge accumulates in response to applied mechanical stress. Inversely, by applying an electrical field to a piezoelectric material, the material will undergo a deformation resulting in a displacement.

Where in embodiments of the present invention reference is made to an actuator, reference is made to an active element, for instance comprising piezoelectric material and electrodes, preferably in a form of a piezoceramic block or stack of different piezoceramic layers. An actuator, used in embodiments of the invention can be of any of the following types: piezoelectric, magnetostrictive, electrostrictive actuators.

Where in embodiments of the present invention reference is made to a motor, e.g. a piezo motor, reference is made to a motor comprising an actuator, for instance a piezoelectric ceramic actuator. Where in embodiments of the invention reference is made to a suspension or suspension foil, reference is made to a component or mechanism that supports the motor and pushes it against the load with a force resulting in a preload.

Where in embodiments of the invention reference is made to contact, reference is made to a location where for instance a tip of a motor, according to embodiments of the invention, touches the surface of the driven object.

Where in embodiments of the invention reference is made to fixation positions, reference is made to positions/locations where the flexible hinges are fixated to the piezo motor.

Where in embodiments of the invention reference is made to preload, reference is made to a static force acting on an actuator or a motor, according to embodiments of the invention, substantially acting perpendicularly to the moving direction of the load.

Where in embodiments of the invention reference is made to load or stage, reference is made to a component or structure (to be) driven by a motor according to embodiments of the invention.

It is to be noted that the outer shape of the piezo motor element is not limiting for embodiments of the present invention. By way of illustration, embodiments of the present invention not being limited thereto, particular embodiments will be described with reference to a piezo motor element having a same outer shape as described in European patent application publication no. EP 3535842 A1 in the name of the present applicant, and such a piezo motor element may be driven in the same way as described in European patent application publication no. EP 3535842 A1, e.g. using the same modes. EP 3535842 A1 discloses that electrodes may be electrically connected and configured such that, taking into account the polarity of the piezo material, the driving of the electrodes induces an in-plane bending mode and/or an in-plane expansion mode. In preferred embodiments of EP 3535842 A1, a resonant mode is achieved by exciting or energizing two electrode pairs by two AC voltages with varying phase difference between the two AC voltages and/or varying voltage amplitude(s). These voltages excite the horizontal eigenmode, e.g. an in-plane bending mode, and vertical eigenmode, e.g. an in-plane expansion mode, of the actuator, resulting in an elliptical motion of the contact zone. When the contact zone (tip) is pushed against a surface, this surface is driven relative to the actuator, with speed and sense depending on the chosen trajectory.

Nevertheless, embodiments of the present invention are not limited by the outer shape of the piezo motor element or by the modes used for driving the piezo motor element, but by the features as defined in the independent claims.

Whereas in examples of embodiments of the present invention reference may be made to certain excitation modes, embodiments are not limited thereto and also encompass piezo motors driven using different excitation modes.

In a first aspect, the present invention relates to a piezo actuator comprising a piezo motor element made of piezo material. The piezo material may be a piezo plate, but embodiments are not limited thereto. The piezo motor element has a top and a bottom surface. The piezo actuator also comprises at least one contact point for contacting the load to be actuated. The at least one contact point is being positioned on the third circumference surface of the ceramic piezo material. In embodiments of the present invention the mounting and contacting is performed at two distinct positions on the piezo material.

The piezo actuator also comprises a connection element. In some embodiments, the connection element comprises two foil elements, i.e. one top connection foil element being positioned at the top side of the piezo motor element and one bottom connection foil element being positioned at the bottom side of the piezo motor element. In some embodiments, a single connection foil or plate is provided. According to embodiments of the present invention, the connection element has arms with flexure hinges for fixating the piezo motor element at different fixation positions positioned at node positions of one or more bending modes of the piezo motor element.

Alternatively, a single connection element with arms comprising flexure hinges contacting the piezo motor element at the circumference surface may be provided.

The flexure hinges are such that the piezo motor element is allowed to move in the normal direction and the flexure hinges are stiff in the tangential direction, whereby the flexure arms are fixed to the piezo motor element with a fixation means.

Embodiments of the present invention furthermore typically may comprise at least one set of electrodes being positioned on the top surface of the piezo material and at least one electrode being positioned at the bottom surface of the ceramic piezo material. The electrodes may be electrically connected and configured such that, taking into account the polarity of the ceramic piezo material, the driving of the electrodes induces an in-plane bending mode and/or an in-plane expansion mode. As will be shown, this can be provided using a flexible circuit, although embodiments are not limited thereto. Further standard and optional features will be illustrated below with reference to exemplary embodiments.

In a second aspect the present invention relates to a motor comprising a piezo actuator as described in the first aspect. Where in embodiments of the present invention reference is given to a motor, reference is given to a combination of at least the actuator as described above in combination with the suspension and a preload being applied.

By way of illustration, the present invention not being limited thereto, the piezo actuator will further be described with reference to the drawings, illustrating standard and optional components of exemplary embodiments of the present invention. It is to be noticed that where reference is made to the motor but elements of the piezo actuator are described, reference is equally made to the actuator as such.

In embodiments of the present invention, the connection comprises two foil element that are placed at the top and bottom side of the motor element. In a particular embodiment, each foil contacts the motor at four places, although embodiments are not limited thereto. At the location of these fixation points, the motor only moves/vibrates in the normal direction (node of the bending mode). The foil element has four arms with flexure hinges that allow for this normal vibration. In the tangential direction, however, the hinges are perfectly stiff. Some examples of materials that can be used are ferro-materials, non-ferro materials, engineering plastics, etc. In a preferred embodiment, the contact between motor element and flexure arm is realised by means of an epoxy adhesive. Alternatively, also other types of glue can be used, such as for example an acrylate or a polyurethane. Nevertheless, alternatively another type of adhesive or even another type of fixation could also be used, such as soldering or brazing. In some embodiments, The shape of the arm ends is designed in such a way that capillary forces acting on the uncured adhesive form a meniscus shape that keeps the adhesive in place during curing.

The combination of a top and bottom connection foils holds the motor element in place by removing two lateral degrees of freedom and all rotational degrees of freedom. This is done without obstructing the intended eigenmodes of the motor and with a very stiff and backlash-free connection in the driving direction.

In some particular embodiments, the connecting foils are separated by a spacer ring and shim rings. This stacked layer of elements is pressed against each other by means of a bolt connection through the central hole. There is no mechanical contact between the motor and connections elements around the central mounting hole of the motor. The outer diameter of the spacer ring is significantly smaller than the inner diameter of the central hole in the piezo motor. In some embodiments, the outer diameter of the spacer ring may be 50µm smaller than the inner diameter of the hole. In some embodiments, substantially smaller than the inner diameter may be less than 90%, e.g. less than 80%, e.g. less than 70% of the inner diameter of the hole. In the vertical/axial direction there is a minimal amount of play between the shim ring and top/bottom surface of the motor. Such an amount of play may be in the range 2 micrometer to 20 micrometer, e.g. around 10 micrometer. During operation, no forces are generated in the vertical/axial direction. Any play in this direction will not cause undesired play or backlash in the driving direction.

Alternatively to a central or non central mounting hole, the connection foils may be kept together by a connection part positioned outside the piezo motor element.

As indicated above, in between motor and connection foils, in some embodiments a flexprint circuit is provided that makes electrical connection to the different electrodes of the motor element. Another solution for this could be simple wires.

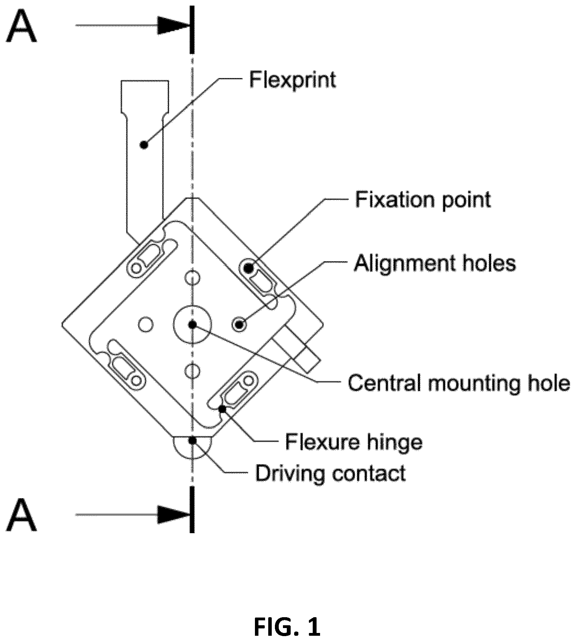

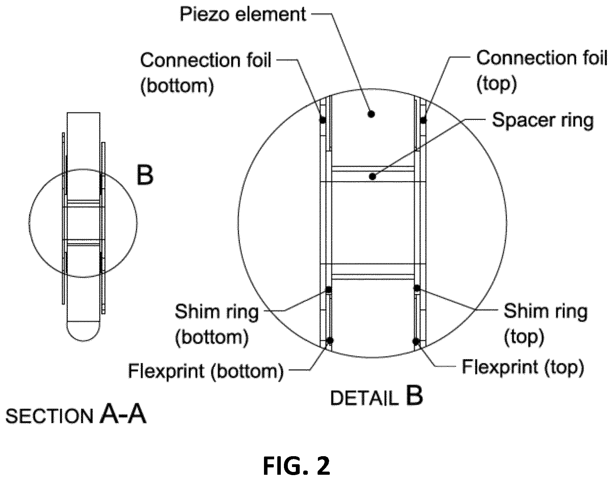

FIG. 1 and FIG. 2 show a first view and cross-sectional view of the piezo motor element and the connection foils as well as, in the present example, the mechanical connection between the connection foils through a hole through the piezo motor element.

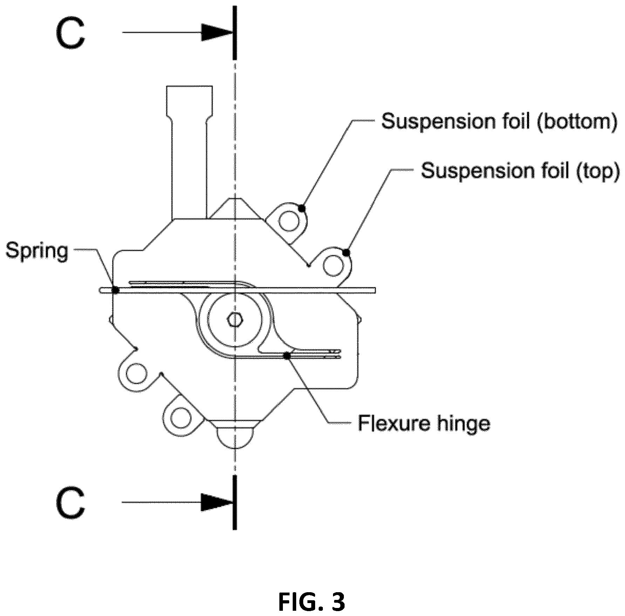

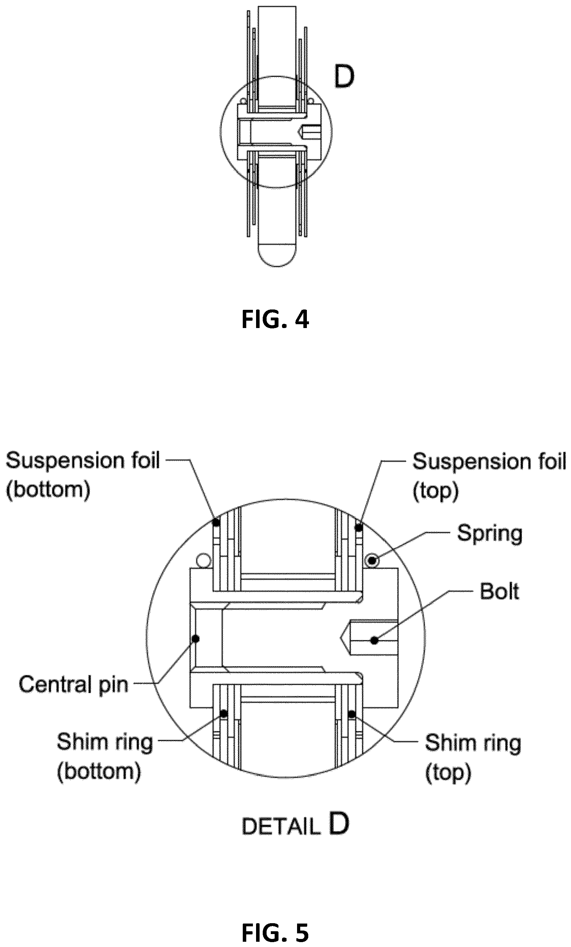

In embodiments of the present invention, the piezo actuator also may comprise a suspension element. In some embodiments, the suspension element may be two suspension layers. In one embodiment, the suspension element adds another foil at both top and bottom side of the motor. In some embodiments, a piezo with two connection foils mounted on a suspension structure, e.g. a thick suspension element, is provided. The systems may provide sufficient tilt stiffness. The function of these foils is to allow the motor element to move freely in a direction perpendicular to the driving direction while preventing undesired motion in the driving direction. These suspension foils are again provided with flexure hinges that can move freely over a predetermined distance. Such a distance may be between 0.1 mm and 1 mm, such as for example about 0.5 mm. The hinges are stiff in the driving direction and torsional direction. The suspension foils are in the present example mounted at both sides of the motor element with its connection foils. In between both layers, a shim ring is installed. There exists some flexibility in the vertical/axial direction and two tilt directions. But, this flexibility is not a problem since no forces are generated in these directions. FIG. 3 to FIG. 5 illustrates the suspension layers and how these are configured with respect to the connection layers and the piezo motor element.

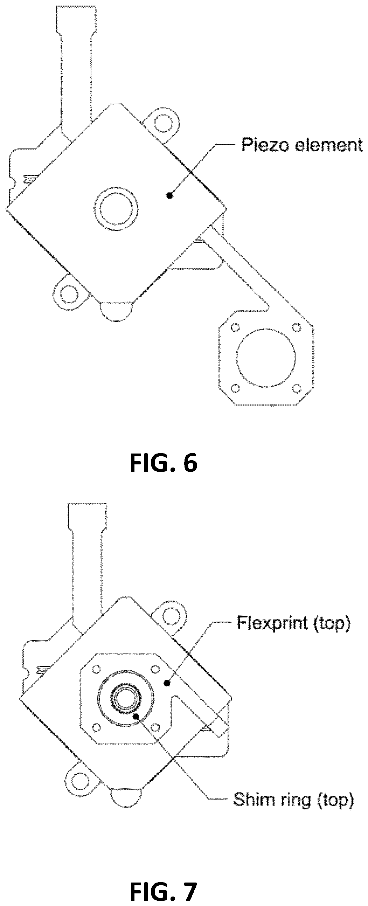

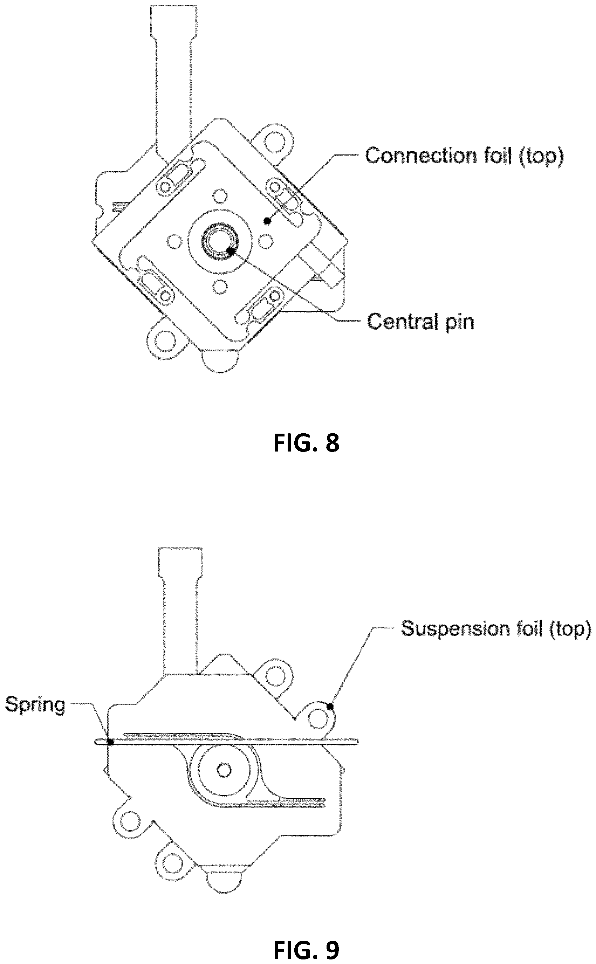

FIG. 6 illustrates the piezo-motor, FIG. 7 illustrates a flexprint, FIG. 8 illustrates a connection foil and FIG. 9 illustrates a suspension foil as can be used in embodiments of the present invention.

It would be possible to use other methods for this suspension function such as a small guideway. Other methods are however not as compact and will introduce mechanical play into the driving direction.

In the present example, the stack of suspension foils, shim ring and connection foils is held together by a bolt and an internally threaded pin going through the central hole of the motor. The tightening torque needs to be sufficient in order to withstand the driving forces and torque of the motor. The central pin also takes care of the alignment of all components.

The combination of motor element with connection layer and suspension layer forms a motor unit that is easily installed on the stator of positioning device. The last element is a spring that pushes the driving contact of the motor against the traction surface of the device. The spring may be a simple U-shaped spring that gives an equal preload at top and both side of the motor unit. Again, other solution are possible, but this U-shaped spring results in a very compact realisation.

In one particular embodiment, a connection layer and a suspension layer could be combined in a single layer. In another particular embodiment, electrical connection, e.g. through a flexible circuit, and mechanical connection could be combined in a single layer.

Whereas in the above exemplary embodiments, the different parts of the connection element or of the connection element and the suspension element are kept together using a bolt and screw connection, alternative means for keeping these parts together could be used such as for example press-fit connections, shrink-fit connections, adhesives and alike.

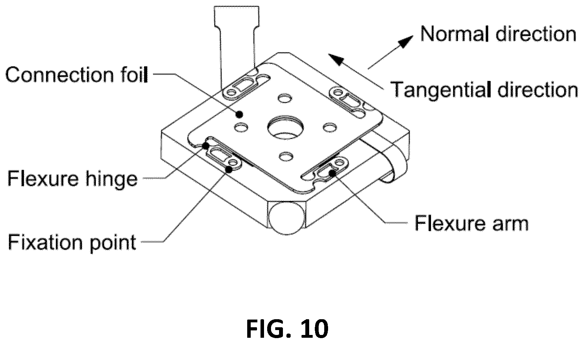

In one particular embodiment, a square shaped piezo element is used, whereby the connection foil is connected to the piezo element through fixation points, one at each side of the piezo element, where the connection foil is fixed to the piezo element through flexure arms and hinges. An example of such an embodiment is shown in FIG. 10.

Further by way of illustration, a piezo motor according to embodiments of the present invention is illustrated in FIG. 10. The different directions applicable in the system are illustrated in the drawing. It can be seen that the fixation points for fixing the hinges to the piezo are located on a node of the bending mode. The fixation points are positioned on a node of the bending mode. The length direction (longitudinal direction) of the arms is perpendicular to the local direction of movement of the other mode. Such mode may be a bending mode or an expansion mode. The length direction is defined by the line connecting the hinge with the fixation point.

It is to be noted that, whereas in embodiments of the present invention illustrated above, use is made of a bending mode and expansion mode, embodiments of the present invention also may make use of other bending modes, whereby the fixation points are positioned in the nodes of the bending modes. The flexible hinges are positioned perpendicular to the local movement of the other modes.

In another aspect, the present invention relates to a piezo actuator comprising a piezo motor element having a top and a bottom surface, and a connection element comprising two foil elements being one top connection foil element being positioned at the top side of the piezo motor element and one bottom connection foil element positioned at the bottom side of the piezo motor element, the top and bottom connection foil element contacting the piezo motor element at different fixation positions respectively at the top surface of the piezo element and at the bottom surface of the piezo motor element, the connection element thus holding the piezo motor element in place without obstructing the eigenmodes of the piezo motor element at resonance.

According to embodiments of the present invention, the piezo motor element has a hole extending through the piezo motor element from the top surface to the bottom surface. This hole may be positioned centrally, or may be positioned at any other suitable position. According to embodiments of the present invention, the connection element further comprises a connection part positioned through the hole in the piezo motor element, the connection part mechanically connecting the top connection foil element and the bottom connection foil element, whereby the different fixation positions are positioned away from the hole, so that at the position of the hole, the connection element and the piezo motor element are not in contact with each other. The piezo motor element may be as described in the first aspect. The connection element may be as described in the first aspect. The piezo actuator also may comprise a suspension element, which may in one example be as described in the first aspect.

According to embodiments of the present invention, the connection part may for example comprise a bolt and screw holding the elements together. Nevertheless, alternatives such as press-fit connections, shrink-fit connections, adhesives and alike also may be used.

Further characteristics may be as described in the first aspect.

Elements of the piezo actuator or the motor may further be as described in European patent application publication no. EP 3535842 A1, although embodiments are not limited thereto.

## Claims

1. A piezo actuator comprising
- a piezo motor element having a top and a bottom surface, and
- a connection element comprising arms with flexure hinges for contacting the piezo motor element at different fixation positions located at node positions of one or more bending modes of the piezo motor element,
whereby the flexure arms are fixed to the piezo motor element with a fixation means,
**characterised in that** a longitudinal direction of the arms with flexure hinges is arranged perpendicularly to the movement of an expansion mode at their respective fixation positions such that, at said fixation
positions, the piezo motor element is only allowed to move in a radial direction with respect to a center position.

2. The piezo actuator according to claim 1, wherein said flexure hinges are stiff in a tangential direction.

3. The piezo actuator according to any of the preceding claims, wherein said connection element comprises four arms with flexure hinges.

4. The piezo actuator according to any of the preceding claims, wherein the flexure arms are fixed to the piezo motor element using an adhesive.

5. The piezo actuator according to any of the preceding claims, wherein the connection element comprises two foil elements being one top connection foil element being positioned at the top side of the piezo motor element and one bottom connection foil element positioned at the bottom side of the piezo motor element, the top and bottom connection foil element having the arms with flexure hinges for contacting the piezo motor element and being configured for contacting the piezo motor element respectively at the top surface of the piezo element and at the bottom surface of the piezo motor element.

6. The piezo actuator according to claim 5, wherein the piezo motor element has a hole extending through the piezo motor element from the top surface to the bottom surface, and wherein the connection element further comprises a connection part positioned through the hole in the piezo motor element, the connection part mechanically connecting the top connection foil element and the bottom connection foil element.

7. The piezo actuator according to claim 6, whereby the different fixation positions are positioned away from the hole, so that at the position of the hole, the connection element and the piezo motor element are not in contact with each other.

8. The piezo actuator according to claim 7, wherein the connection part comprises a spacer ring for spacing the top connection foil element and the bottom connection foil element.

9. The piezo actuator according to claim 8, wherein the outer diameter of the spacer ring is substantially smaller than the inner diameter of the hole in the piezo motor element.

10. The piezo actuator according to any of claims 6 to 9, wherein the connection part comprises two shim elements, e.g. shim rings, assisting in providing mechanical connection between the top connection foil element and the bottom connection foil element and spacing the foil elements from the piezo motor element.

11. The piezo actuator according to claim 10, wherein the dimensions of the connection part are such that there is play between the shim elements and the top and bottom surface of the piezo motor element in the order of 2 µm to 20 µm.

12. The piezo actuator according to any of the preceding claims in as far as dependent on claim 5, wherein between the piezo motor element and the connection foils a flexible circuit is provided for electrical connection to electrodes in the piezo motor element.

13. The piezo actuator according to any of the preceding claims, wherein the piezo actuator furthermore comprises a suspension element for suspending the piezo motor element in such a way that the piezo motor element can move freely in a direction perpendicular to the driving direction while preventing undesired motion in the driving direction.

14. The piezo actuator according to claim 13, wherein the suspension element comprises two suspension foils, one suspension foil positioned at the top side of the piezo motor element and one suspension foil being positioned at the bottom side of the piezo motor element.

15. The piezo actuator according to claim 14 in as far as dependent on claim 5, wherein the suspension foils are positioned such that the suspension foils are positioned at the sides of the connection foils facing away from the piezo motor element and that the suspension foils and the connection foils are spaced from each other with shim elements.

16. The piezo actuator according to claim 15, wherein the suspension foils, the shim elements and the connection foils are mechanically connected to each other.

17. The piezo actuator according to claim 16, wherein the suspension foils, the shim elements and the connection foils are mechanically connected to each other using a connection part extending through the central hole of the piezo motor element.

18. The piezo actuator according to any of the preceding claims, wherein the piezo motor element is plate shaped.

## Patentansprüche

1. Piezoaktor, umfassend:
- ein Piezomotor-Element, das eine obere und eine untere Fläche aufweist, und
- ein Verbindungselement, das Arme mit Biegegelenken zum Kontaktieren des Piezomotor-Elements an verschiedenen Befestigungspositionen umfasst, die sich an Knotenpositionen eines oder mehrerer Biegemodi des Piezomotor-Elements befinden,
wobei die Biegearme am Piezomotor-Element mit einem Befestigungsmittel befestigt sind,
**dadurch gekennzeichnet, dass** eine Längsrichtung der Arme mit Biegegelenken senkrecht zur Bewegung eines Expansionsmodus an ihren jeweiligen Befestigungspositionen verläuft, so dass an den Befestigungspositionen es dem Piezomotor-Element nur möglich ist, sich in einer radialen Richtung bezüglich einer mittleren Position zu bewegen.

2. Piezoaktor nach Anspruch 1, wobei die Biegegelenke in einer tangentialen Richtung steif sind.

3. Piezoaktor nach einem der vorhergehenden Ansprüche, wobei das Verbindungselement vier Arme mit Biegegelenken umfasst.

4. Piezoaktor nach einem der vorhergehenden Ansprüche, wobei die Biegearme am Piezomotor-Element mit einem Klebstoff befestigt sind.

5. Piezoaktor nach einem der vorhergehenden Ansprüche, wobei das Verbindungselement zwei Folienelemente umfasst, nämlich ein oberes Verbindungs-Folienelement, das an der Oberseite des Piezomotor-Elements positioniert ist, und ein unteres Verbindungs-Folienelement, das an der Unterseite des Piezomotor-Elements positioniert ist, wobei das obere und das untere Verbindungs-Folienelement die Arme mit Biegegelenken zum Kontaktieren des Piezomotor-Elements aufweisen und dafür ausgelegt sind, das Piezomotor-Element an der oberen Fläche des Piezomotor-Elements bzw. an der unteren Fläche des Piezomotor-Elements zu kontaktieren.

6. Piezoaktor nach Anspruch 5, wobei das Piezomotor-Element ein Loch aufweist, das sich durch das Piezomotor-Element von der oberen Fläche zur unteren Fläche erstreckt, und wobei das Verbindungselement ferner ein Verbindungsteil umfasst, das durch das Loch im Piezomotor-Element hindurch positioniert ist, wobei das Verbindungsteil das obere Verbindungs-Folienelement und das untere Verbindungs-Folienelement mechanisch verbindet.

7. Piezoaktor nach Anspruch 6, wobei die verschiedenen Befestigungspositionen von dem Loch entfernt positioniert sind, so dass an der Position des Lochs das Verbindungselement und das Piezomotor-Element sich nicht miteinander in Kontakt stehen.

8. Piezoaktor nach Anspruch 7, wobei das Verbindungsteil einen Distanzring zum Anordnen des oberen Verbindungs-Folienelements und des unteren Verbindungs-Folienelements mit Abstand umfasst.

9. Piezoaktor nach Anspruch 8, wobei der Außendurchmesser des Distanzringes wesentlich kleiner als der Innendurchmesser des Lochs im Piezomotor-Element ist.

10. Piezoaktor nach einem der Ansprüche 6 bis 9, wobei das Verbindungsteil zwei Ausgleichselemente, z. B. Passscheiben, umfasst, die zum Gewährleisten einer mechanischen Verbindung zwischen dem oberen Verbindungs-Folienelement und dem unteren Verbindungs-Folienelement und Anordnen der Folienelemente im Abstand von dem Piezomotor-Element beitragen.

11. Piezoaktor nach Anspruch 10, wobei die Abmessungen des Verbindungsteils so beschaffen sind, dass ein Spiel zwischen den Ausgleichselementen und der oberen und unteren Fläche des Piezomotor-Elements in der Größenordnung von 2 µm bis 20 µm vorhanden ist.

12. Piezoaktor nach einem der vorhergehenden Ansprüche, sofern von Anspruch 5 abhängig, wobei zwischen dem Piezomotor-Element und den Verbindungsfolien eine flexible Schaltung zur elektrischen Verbindung mit Elektroden im Piezomotor-Element vorgesehen ist.

13. Piezoaktor nach einem der vorhergehenden Ansprüche, wobei der Piezoaktor ferner ein Aufhängungselement zum Aufhängen des Piezomotor-Elements auf eine solche Weise umfasst, dass sich das Piezomotor-Element frei in einer Richtung senkrecht zur Antriebsrichtung bewegen kann, während eine unerwünschte Bewegung in der Antriebsrichtung verhindert wird.

14. Piezoaktor nach Anspruch 13, wobei das Aufhängungselement zwei Aufhängungsfolien umfasst, wobei eine Aufhängungsfolie an der Oberseite des Piezomotor-Elements positioniert ist und eine Aufhängungsfolie an der Unterseite des Piezomotor-Elements positioniert ist

15. Piezoaktor nach Anspruch 14, sofern von Anspruch 5 abhängig, wobei die Aufhängungsfolien so positioniert sind, dass die Aufhängungsfolien an den vom Piezomotor-Element abgewandten Seiten der Verbindungsfolien positioniert sind und dass die Aufhängungsfolien und die Verbindungsfolien mit Ausgleichselementen im Abstand voneinander angeordnet sind.

16. Piezoaktor nach Anspruch 15, wobei die Aufhängungsfolien, die Ausgleichselemente und die Verbindungsfolien mechanisch miteinander verbunden sind.

17. Piezoaktor nach Anspruch 16, wobei die Aufhängungsfolien, die Ausgleichselemente und die Verbindungsfolien unter Verwendung eines Verbindungsteils mechanisch miteinander verbunden sind, das sich durch das zentrale Loch des Piezomotor-Elements erstreckt.

18. Piezoaktor nach einem der vorhergehenden Ansprüche, wobei das Piezomotor-Element plattenförmig ist.

## Revendications

1. Actionneur piézoélectrique comprenant
- un élément moteur piézoélectrique ayant une surface supérieure et une surface inférieure, et
- un élément de raccordement comprenant des bras avec des charnières de flexion pour entrer en contact avec l'élément moteur piézoélectrique à différentes positions de fixation situées à des positions nodales d'un ou de plusieurs modes de flexion de l'élément moteur piézoélectrique,
de sorte que les bras de flexion sont fixés à l'élément moteur piézoélectrique avec un moyen de fixation,
**caractérisé en ce qu'**une direction longitudinale des bras avec des charnières de flexion est agencée perpendiculairement au mouvement d'un mode d'expansion au niveau de leurs positions de fixation respectives de telle sorte que, au niveau desdites positions de fixation, l'élément moteur piézoélectrique est seulement autorisé à se déplacer dans une direction radiale par rapport à une position centrale.

2. Actionneur piézoélectrique selon la revendication 1, dans lequel lesdites charnières de flexion sont rigides dans une direction tangentielle.

3. Actionneur piézoélectrique selon l'une quelconque des revendications précédentes, dans lequel ledit élément de raccordement comprend quatre bras avec des charnières de flexion.

4. Actionneur piézoélectrique selon l'une quelconque des revendications précédentes, dans lequel les bras de flexion sont fixés à l'élément moteur piézoélectrique à l'aide d'un adhésif.

5. Actionneur piézoélectrique selon l'une quelconque des revendications précédentes, dans lequel l'élément de raccordement comprend deux éléments en feuille constitués par un élément de raccordement en feuille supérieur positionné au niveau du côté supérieur de l'élément moteur piézoélectrique et par un élément de raccordement en feuille inférieur positionné au niveau du côté inférieur de l'élément moteur piézoélectrique, l'élément de raccordement en feuille supérieur et l'élément de raccordement en feuille inférieur ayant les bras avec des charnières de flexion pour entrer en contact avec l'élément moteur piézoélectrique et étant configurés pour entrer en contact avec l'élément moteur piézoélectrique respectivement au niveau de la surface supérieure de l'élément piézoélectrique et au niveau de la surface inférieure de l'élément moteur piézoélectrique.

6. Actionneur piézoélectrique selon la revendication 5, dans lequel l'élément moteur piézoélectrique comporte un trou s'étendant à travers l'élément moteur piézoélectrique depuis la surface supérieure jusqu'à la surface inférieure, et dans lequel l'élément de raccordement comprend en outre une partie de raccordement positionnée à travers le trou dans l'élément moteur piézoélectrique, la partie de raccordement raccordant mécaniquement l'élément de raccordement en feuille supérieur et l'élément de raccordement en feuille inférieur.

7. Actionneur piézoélectrique selon la revendication 6, de sorte que les différentes positions de fixation sont positionnées à l'écart du trou, de telle sorte qu'au niveau de la position du trou, l'élément de raccordement et l'élément moteur piézoélectrique ne sont pas en contact l'un avec l'autre.

8. Actionneur piézoélectrique selon la revendication 7, dans lequel la partie de raccordement comprend une bague d'espacement pour espacer l'élément de raccordement en feuille supérieur et l'élément de raccordement en feuille inférieur.

9. Actionneur piézoélectrique selon la revendication 8, dans lequel le diamètre extérieur de la bague d'espacement est sensiblement plus petit que le diamètre intérieur du trou dans l'élément moteur piézoélectrique.

10. Actionneur piézoélectrique selon l'une quelconque des revendications 6 à 9, dans lequel la partie de raccordement comprend deux éléments de calage, par exemple des bagues de calage, aidant à fournir un raccordement mécanique entre l'élément de raccordement en feuille supérieur et l'élément de raccordement en feuille inférieur et à espacer les éléments en feuille de l'élément moteur piézoélectrique.

11. Actionneur piézoélectrique selon la revendication 10, dans lequel les dimensions de la partie de raccordement sont telles qu'il y a un jeu entre les éléments de calage et la surface supérieure et inférieure de l'élément moteur piézoélectrique de l'ordre de 2 µm à 20 µm.

12. Actionneur piézoélectrique selon l'une quelconque des revendications précédentes dans la mesure où elles dépendent de la revendication 5, dans lequel entre l'élément moteur piézoélectrique et les feuilles de raccordement un circuit souple est prévu pour un raccordement électrique à des électrodes dans l'élément moteur piézoélectrique.

13. Actionneur piézoélectrique selon l'une quelconque des revendications précédentes, dans lequel l'actionneur piézoélectrique comprend en outre un élément de suspension pour suspendre l'élément moteur piézoélectrique de telle sorte que l'élément moteur piézoélectrique peut se déplacer librement dans une direction perpendiculaire à la direction d'entraînement tout en empêchant un mouvement indésirable dans la direction d'entraînement.

14. Actionneur piézoélectrique selon la revendication 13, dans lequel l'élément de suspension comprend deux feuilles de suspension, une feuille de suspension positionnée au niveau du côté supérieur de l'élément moteur piézoélectrique et une feuille de suspension étant positionnée au niveau du côté inférieur de l'élément moteur piézoélectrique.

15. Actionneur piézoélectrique selon la revendication 14 dans la mesure où elle dépend de la revendication 5, dans lequel les feuilles de suspension sont positionnées de telle sorte que les feuilles de suspension sont positionnées sur les côtés des feuilles de raccordement tournés loin de l'élément moteur piézoélectrique et que les feuilles de suspension et les feuilles de raccordement sont espacées les unes des autres par des éléments de calage.

16. Actionneur piézoélectrique selon la revendication 15, dans lequel les feuilles de suspension, les éléments de calage et les feuilles de raccordement sont mécaniquement raccordés les uns aux autres.

17. Actionneur piézoélectrique selon la revendication 16, dans lequel les feuilles de suspension, les éléments de calage et les feuilles de raccordement sont mécaniquement raccordés les uns aux autres à l'aide d'une partie de raccordement s'étendant à travers le trou central de l'élément moteur piézoélectrique.

18. Actionneur piézoélectrique selon l'une quelconque des revendications précédentes, dans lequel l'élément moteur piézoélectrique est en forme de plaque.
